# EUROPEAN PATENT APPLICATION

(11) **EP 4 836 595 A1**
(43) Date of publication of application: **04.11.2026**
(21) Application number: 25173512.2
(22) Date of filing: 30.04.2025
(51) Int. Cl.: H05K 1/02

(54) **DEVICE AND SYSTEM WITH A PRINTED CIRCUIT BOARD**

(71) Applicant: Magna Electronics Sweden AB, 447 37 Vårgårda (SE)
(72) Inventor: ROMBO, Lars, 583 30 Linköping (SE); CHENG, Kelvin, Ontario L6G 1C9 (CA); LODIGE, Gunnar, 583 30 Linköping (SE)
(74) Representative: Müller Verweyen

(57) **Abstract**

Device (1) with a printed circuit board (PCB) (2), wherein the PCB (2) comprises
- a top surface (3),
- a bottom surface (4) on an opposite side of the top surface (3),
- a screw hole (5) for receiving a screw (7), and
- a curved elongated through-hole (6), wherein
- a specific length (13) of the PCB (2) is defined by the maximum extension of the PCB (2) in a plan view of the top surface (3), wherein
- the elongated through-hole (6) and the screw hole (5) are assigned to a common reference point (11) that is located on an outer contour (10) of the PCB (2), wherein
- the elongated through-hole (6) and the screw hole (5) that are assigned to the common reference point (11) are located entirely within a distance of less than 1/4 of the specific length (13) from the common reference point (11).

## Description

The invention relates to a device according to the preamble of claim 1 and to a system according to the preamble of claim 15.

CN 215420953 U discloses a printed circuit board (PCB) stress protection structure comprising a printed circuit board with a ball grid array (BGA) chip mounted thereon. The PCB features a screw hole, which is identified as a source of stress. In order to protect the BGA chip from the stress generated in the area of the screw hole, a stress protection groove penetrating the PCB is arranged at a position between the BGA chip and the screw hole. Two types of a stress protection groove are disclosed. According to a first example, the PCB has one single stress protection groove, which is linear and parallel to an edge of the BGA chip. According to a second example, the PCB has two crescent shape stress protection grooves, wherein the crescent directions of the two stress protection grooves are opposite. The design of the disclosed stress protection grooves ensures that the stress-sensitive BGA chip is not damaged by changing the transmission path of the stress generated in the area of the screw hole, thereby achieving the objective of reducing the stress acting on the BGA chip.

It is an object of the invention to provide a device with a PCB and a corresponding system that has an improved ability to withstand mechanical stress.

The invention solves this objective with the features of the independent claims. Further preferred embodiments of the invention can be found in the dependent claims and the associated description and drawings.

According to a first aspect of the invention a device with a printed circuit board (PCB) is proposed, wherein the PCB comprises a top surface, a bottom surface on an opposite side of the top surface, a screw hole for receiving a screw, and a curved elongated through-hole, wherein a specific length of the PCB is defined by the maximum extension of the PCB in a plan view of the top surface, wherein the elongated through-hole and the screw hole are assigned to a common reference point that is located on an outer contour of the PCB, wherein the elongated through-hole and the screw hole that are assigned to the common reference point are located entirely within a distance of less than 1/4, preferably of less than 1/8, more preferably of less than 1/10, of the specific length from the common reference point.

First, some terms used in the context of this application are explained.

A screw hole in the sense of this application is any hole that is configured to receive a screw. Preferably, the screw hole is a through-hole. For example, in a plan view of the top surface, the screw hole may be circular.

A plan view of the top surface in the sense of this application corresponds to a viewing direction in the direction of the surface normal of the top surface of the PCB.

A specific length of the PCB is defined by the maximum extension of the PCB in a plan view of the top surface. Therefore, the distance between two most distant points on an outer contour of the PCB in a plan view of the top surface defines the specific length.

The outer contour of the PCB in the sense of this application can be determined in a plan view of the top surface or in a plan view of the bottom surface.

A corner in the sense of this application may be a sharp corner defined by a point (from a mathematical point of view) in a plan view of the top surface, but a corner may also have a complex geometry (e.g., it may be a rounded corner or a bevel) that is defined by a line. In the case of a straight edge line, the point of transition from the edge line to the corner may be characterized by the beginning of a curvature of the outer contour of the PCB, or, in the case of curved edge lines, by a point of inflection or by a significant increase in curvature.

A screw can be inserted into the screw hole to mount the PCB to a carrier. In various applications, for example, in a vehicle, the carrier is exposed to mechanical forces and temperature variations. These environmental effects are transferred from the carrier to the PCB via the screw. However, the arrangement of the screw hole and the elongated through-hole close to each other and close to a reference point, i.e. close to an outer contour of the PCB, has the effect that mechanical forces applied in the area of the screw hole, which cause tension in the PCB, can be at least partially compensated by means of the elongated through-hole, which increases the elasticity of the PCB. Strain reduction is achieved by compressing and expanding the elongated through-hole. This allows a more flexible connection to a carrier, such as a mechanical housing. This elongated through-hole compression and expansion may be caused by extreme temperatures, both cold and hot, in an electronic design's mission profile, e.g. for automotive and/or aerospace applications. Strain reduction results in reduced solder joint cracking and open solder joints. Additionally, strain reduction eliminates the need for preventive additions of epoxy and underfill material to secure the components. Furthermore, the arrangement of the screw hole and the elongated through-hole close to the outer contour has the effect that mechanical strain can be diverted to a free corner and/or edge of the PCB. As a result, the electrical components, for example electronic components, connected to the PCB on its top surface, are isolated from mechanical strain. Thus, the reliability of the PCB and thus the lifetime can be increased.

According to a preferred embodiment, a plurality of curved elongated through-holes and the screw hole are assigned to the common reference point. This embodiment is particularly advantageous if the reference point is not a point of the corner. In such cases, the screw hole is more centrally located on the PCB. The plurality of elongated through-holes, e.g. two elongated through-holes, may be used to effect strain reduction in multiple directions. This ensures a balanced distribution of stress and improves the overall durability of the system. Preferably, the plurality of elongated through-holes belonging to the same group as the screw hole are spaced apart at an angle with respect to the center point of said screw hole, which is, for example, at least 10°; i.e., the elongated through-holes assigned to the same group do not have any overlapping angle ranges with respect to the center point of the screw hole. The area between two adjacent elongated holes can also be referred to as transition cross section of the PCB.

Preferably, in a plan view of the top surface, the elongated through-hole may be located between a strain-sensitive electric component and the screw hole that is assigned to the same reference point as the elongated through-hole.

If a plurality of elongated through-holes are assigned to the common reference point, at least one, a subset or each of said elongated through-holes may be located between a strain-sensitive electric component and the screw hole that is assigned to the same reference point as the plurality of elongated through-holes.

Preferably, the common reference point of a group consisting at least one screw hole and at least one elongated through-hole is the point on the outer contour of the PCB that is closest to the screw hole of said group.

Preferably, in a plan view of the top surface, the outer contour of the PCB comprises at least one corner and at least two edge lines that extend towards the corner, wherein the corner forms a transition between the two edge lines, wherein the common reference point is a point on the corner. Preferably, the two edge lines that extend towards the corner are straight or essentially straight. The two edges lines may run to each other at an angle between 70° and 110°, preferably at an angle between 80° and 100°, more preferably at an angle of 90°. It goes without saying that this refers to an interior angle. Due to the arrangement of the reference point on the corner, the screw hole and the elongated through-hole are located within a corner portion of the PCB. As a result, the mechanical stresses can be diverted to the free edges of the PCB that extend towards the corner with said reference point.

Preferably, the common reference point is defined by a point of the corner with the maximum degree of curvature in a plan view of the top surface; or the corner extends along a path that defines a corner length, wherein the reference point is a midpoint that divides the path into two sections of equal length. This arrangement of the reference point allows mechanical stresses to be transferred from the screw hole almost uniformly to the neighboring free edges. For example, if the radius of the corner is constant, the midpoint is preferably used as the reference point; in this case, preferably, two straight lines extend towards the corner.

Preferably, in a plan view of the top surface, the PCB has a polygonal basic shape, wherein the corner on which the reference point is located is a corner defining the polygonal basic shape. This means that for a PCB with a basic shape of a polygon with n corners, the reference point is located on one of the n corners. In other words, the reference point is not located on recesses or protrusions that are relatively small compared to the dimensions of the PCB; i.e. they have a maximum dimension that is less than preferably 1/5, more preferably less than 1/10 or less than 1/20, of the specific length of the PCB.

Further preferably, in a plan view of the top surface, the outer contour of the PCB has a rectangular basic shape; it may have sharp and/or rounded corners.

Preferably, the average distance of the screw hole to the reference point is less than the average distance of the elongated through-hole to the reference point. This allows most of the mechanical stress from the screw hole to be diverted to a free edge or edges; in addition, the elongated through-hole, which has a larger distance from the reference point, acts as a measure to further reduce the mechanical stress acting on the PCB. The average distance is the arithmetic mean of the distances of all points of the screw hole or the elongated through-hole to the reference point.

Preferably, at least one electrical component is located on the top surface of the PCB and is electrically connected to the PCB, wherein the distance between the furthest point of the elongated through hole to the reference point is less than the smallest distance between the reference point and the electrical component that is closest to the reference point. As a result, the electrical components on the top surface of the PCB are better protected from mechanical stress generated in the area of the screw hole.

Preferably, the maximum width of the elongated through-hole is 0.4 to 2 mm, more preferably the maximum width of the elongated through-hole is 0.4 to 1.6, further preferably 1 to 1.5 mm. The width can be varied to accommodate the free space around the screw hole. A narrower slot allows more surface area for electrical component placement. The definition of the width, of course, refers to plan view of the top surface. More preferably, the elongated through-hole has a constant width of 0.4 mm to 2 mm; 0.4 mm to 1.6 mm; or 1 mm to 1.5 mm along half, three quarters or the entire elongated extension of the elongated through-hole, in the latter case not taking into account possible end regions of the elongated through-hole provided with a radius.

Preferably, the smallest distance from the elongated through-hole to the outer contour of the PCB is 3 mm to 4 mm. This results in a favorable compromise between the stability of the PCB and the ability to compensate for mechanical stress.

Preferably, in a plan view of the top surface, the elongated through-hole extends over an angle between 60° and 120° defined by two straight angle-defining lines running through a center point of the screw hole that is assigned to the same reference point as the elongated through-hole, wherein the straight angle-defining lines traverse the outer contour of said elongated through-hole. This allows for the compensation of mechanical stresses over a relatively large angular range, so that on the side of the elongated through-hole facing away from the screw hole, there is little or no mechanical stress on a relatively large area and the electrical components located there.

Further preferably, in a plan view of the top surface, the longitudinal extension of the elongated through-hole is larger than a diameter of the screw hole that is located within the same corner portion as the elongated through-hole.

Preferably, the PCB comprises a plurality of groups, each consisting of one screw hole and at least one elongated through-hole, wherein each group is assigned to a different reference point that is located on the outer contour of the PCB. Further preferably, at least one of the plurality of groups, a subset of the plurality of groups or each of the plurality of groups may consist of one screw hole and two elongated through-holes. Alternatively, at least one of the plurality of groups, a subset of the plurality of groups or each of the plurality of group may be a pair of screw hole and elongated through-hole. For example, each different reference point is located on a different corner of the PCB; additionally or alternatively, reference points may also be located on the edge lines. This allows to evenly distribute mechanical strain from the screw holes.

Preferably, in a plan view of the top surface, an axis of symmetry that extends through the reference point and a center point of the screw hole crosses the elongated through-hole that is assigned to the same reference point as said screw hole, wherein in a plan view of the top surface, the elongated through-hole is symmetric with respect to the axis of symmetry. This further improves the capability to distribute mechanical strain from the screw holes evenly.

Preferably, in a plan view of the top surface, the elongated through-hole is arc-shaped. Further preferably, in a plan view of the top surface, the elongated through-hole comprises a convex side and a concave side, wherein the concave side faces the screw hole that is assigned to the same reference point as the respective elongated through-hole. This means that the elongated through-hole is adapted to the contour of the preferably round screw hole, so that the effect of reducing mechanical strain can be improved.

If the PCB comprises at least one group assigned to a reference point that consists of one screw hole and a plurality of through-holes, the disclosure of this application explicitly includes embodiments, wherein one, a plurality or each of the elongated through-holes of said group is/are designed as described above.

According to a second aspect of the invention a system is proposed comprising a carrier and a screw, wherein the system further comprises a device according to the first aspect of the invention, wherein the screw mounts the PCB to the carrier in a non-detachable manner, wherein the screw protrudes through the screw hole, wherein the smallest distance between the radially outer surface of a screw head of the screw and the elongated through-hole is 1 mm to 2 mm. This reduces the mechanical strain resulting from thermal expansion and contraction and improves the reliability of the system. Preferably, the carrier is a housing. Further preferably, the device according to the first aspect of the invention is located within said housing.

In the following the invention shall be illustrated on the basis of preferred embodiments with reference to the accompanying drawings, wherein:
- Fig. 1: shows a system comprising a device with a PCB in a plan view of the top surface with a reference point located on a corner of PCB;
- Fig. 2: shows a first detailed view of a corner portion of a PCB with a reference point located on a corner of the PCB;
- Fig. 3: shows a second detailed view of a corner portion of a PCB with a reference point located on a corner of the PCB;
- Fig. 4: shows a third detailed view of a corner portion of a PCB with a reference point located on a corner of the PCB;
- Fig. 5: shows a device with a reference point located on an edge line of the PCB;
- Fig. 6: shows a further embodiment of a system; and
- Fig. 7: shows a detailed view of the embodiment shown in Fig-ure 6.

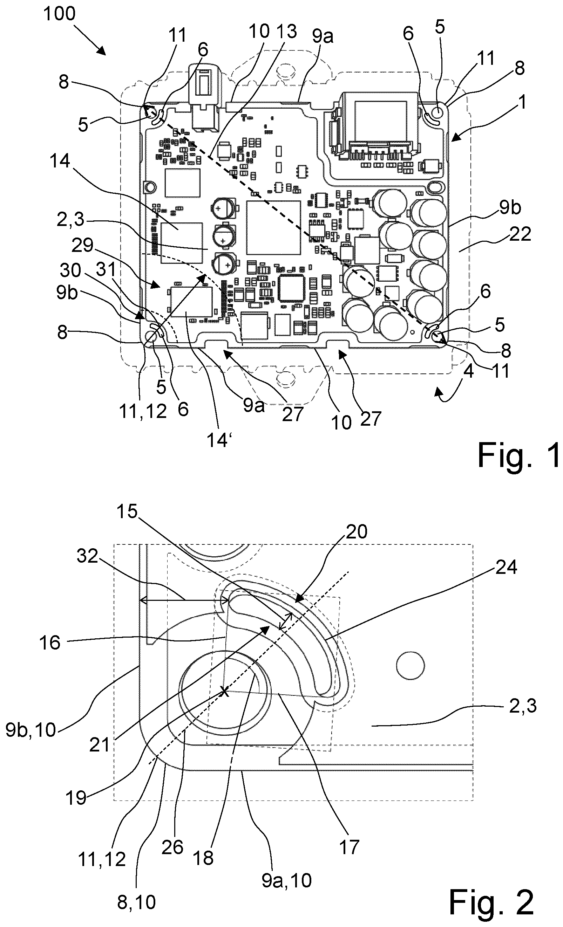

Figure 1 shows a system 100 comprising a device 1 according to a first embodiment with a printed circuit board (PCB) 2. The PCB 2 comprises a top surface 3 and a bottom surface 4. Since Figure 1 shows the PCB 2 in a plan view of the top surface 3, the bottom surface 4 is not visible in Figure 1. The plan view of the top surface 3 of the PCB 2 is the perspective as illustrated in Figures 1 to 5.

The device 1 further comprises a plurality of electrical components 14 of which only one is provided with a reference sign for the sake of a better overview. The electrical components 14 are electrically connected to the PCB 2. A specific length 13 of the PCB 2 is defined by the distance between two most distant points on an outer contour 10 of the PCB 2. The PCB 2 is a rectangle with four rounded corners 8; therefore, the specific length 13 of the PCB 2 is defined by the length of the diagonal of the PCB 2.

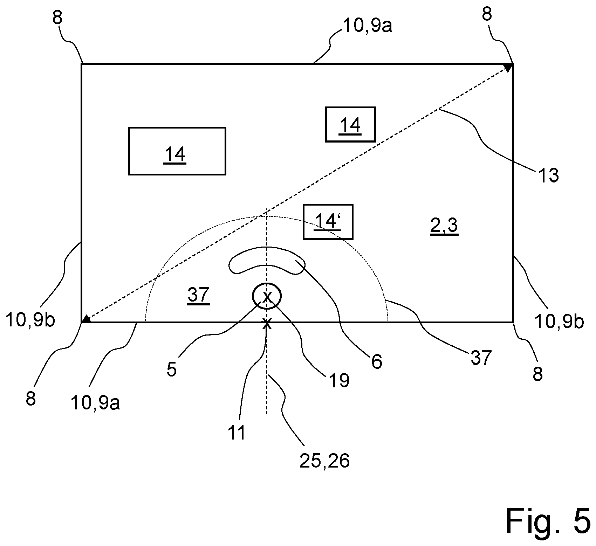

The outer contour 10 of the PCB 2 comprises four corners 8 that define the rectangular basic shape of the PCB 2. In this embodiment, all four corners 8 are rounded corners 8; i.e. each corner 8 extends along a path that defines a corner length. However, sharp corners 8 (cf. Figure 5) that are defined by a point in a plan view of the top surface 3 are also possible. It goes without saying that in practice, a sharp corner 8 is not formed by a single point. Nevertheless, a distinction between sharp and rounded corners 8 is made here for illustrative purposes.

Furthermore, the outer contour 10 of the PCB 2 comprises edge lines 9a and 9b, wherein the corner 8 forms a transition between the two edge lines 9a and 9b. The outer edge lines 9a, 9b of the PCB 2 have recesses 27, but the corners of these recesses 27 do not contribute in defining the rectangular shape of the PCB 2; therefore, the corners of the recesses 27 are not suitable for an arrangement of a reference point 11.

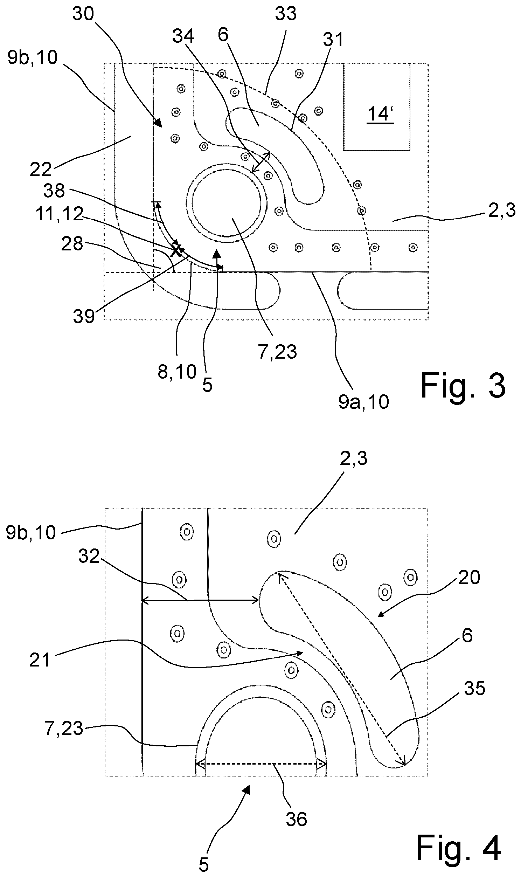

Since the PCB 2 has a rectangular basic shape, the edge lines 9a and 9b extending towards the corner 8 of the PCB 2 define an interior angel 28 of 90°; cf. Figure 3.

The system 100 further comprises a carrier 22, wherein the carrier 22 is a housing, e.g., with an inner space in which the PCB 2 is arranged. However, the carrier 22 may also be designed as any other structure without the interior.

The PCB 2 comprises a plurality of screw holes 5 for receiving a screw 7 each; cf. Figures 3 and 4. Each screw 7 passes through a screw hole 5 and is screwed to the carrier 22 so that the PCB 2 is mounted between the carrier 22 and a screw head 23 of the screw 7 so that it cannot be detached.

Each screw hole 5 of the PCB 2 is located in proximity of a curved elongated through-hole 6. Furthermore, each pair of screw hole 5 and elongated through-hole 6 is located in a distance of less than 1/4, more specifically less than 1/10 of the specific length 13 away from a common reference point 11 that is located on the outer contour 10 of the PCB 2.

According to the first embodiment shown in Figures 1 to 4, the reference point 11 is located on the corner 8 that forms the transition of two neighboring straight edge lines 9a and 9b. More specifically, the common reference point 11 is defined by a midpoint 12 that divides the path that defines the corner length into two sections 38 and 39 of equal length; cf. Figure 3. Since the radius of the corner 8, i.e. the degree of curvature, is constant, the midpoint 12 is used as the reference point 11. The area of the PCB 2 that is located within the distance of less than 1/4 of the specific length from the reference point 11 is denoted as a corner portion 29 of the PCB 2. The screw hole 5 and the elongated through-hole 6 are both located entirely within the corner portion 29. In this embodiment, the screw-hole 5 and the elongated through-hole 6 are both located completely within an even smaller corner portion 30 that is defined by an area of the PCB 2 that is within the distance of less than 1/10 of the specific length 13 from the reference point 11. This applies accordingly to all pairs of screw holes 5 and elongated screw-holes 6, each of which is assigned to a different reference point 11 on different corners 8.

Figure 1 shows that the distance between a furthest point 31 of the elongated through-hole 6 to the corresponding reference point 11 is less than the smallest distance between the reference point 11 and the electrical component 14' that is closest to the reference point 11.

Figure 1 also shows that the average distance of the screw hole 5 to the reference point 11 is less than the average distance of the elongated through-hole 6 to the corner point 8. This means that the screw hole 5 is closer to the reference point than the elongated through-hole 6 that is assigned to the same reference point 11 as the screw hole 5. In other words: The round screw hole 5 is located between the reference point 11 and the elongated through-hole 6; and the elongated through-hole 6 is located between the electrical component 14' and the screw hole 5.

The embodiment shown in Figure 1 is further explained below, with reference to Figures 2 to 4. The drawings are only intended as schematic representation; hence, not every detail from Figure 1 has been reproduced identically in Figures 2 to 4.

Figure 2 shows a first detailed view of the corner portion 30 of the PCB 2 shown in Figure 1. A maximum width 15 of the elongated through-hole 6 is 0.4 to 2 mm, namely 1 to 1.5 mm. Furthermore, the elongated through-hole 6 extends over an angle 18 of 90° defined by two straight angle-defining lines 16 and 17 running through a center point 19 of the screw hole 5. Both, the screw hole 5 and the elongated through-hole 6 are assigned to the same reference point 11. The straight angle-defining lines 16 and 17 traverse an outer contour 24 of said elongated through-hole 6.

Figure 2 also shows an axis of symmetry 26 that extends through the reference point 11 and the center point 19 of the screw hole 5. The axis of symmetry 26 crosses the elongated through-hole 6 that is assigned to the same reference point 11 as said screw hole 5 with the center point 19. In the perspective shown in Figure 2, the elongated through-hole 6 is symmetric with respect to the axis of symmetry 26.

Figure 2 also shows that the elongated through-hole 6 is arc-shaped with a convex side 20 facing the electrical components 14 and a concave side 21 facing the screw hole 5.

Figures 3 and 4 also show the screw 7 with the screw head 23 that is used to mount the PCB 2 in a non-detachable manner to the carrier 22. The screw 7 protrudes through the screw hole 5 and is screwed into a non-visible thread in the carrier 22. Thus, the PCB 2 is held between the carrier 22 and the screw head 23. The dashed line 33 in Figure 3 represents the perimeter of the reference point 11 with a radius of 1/10 of the specific length 13 and the corresponding corner portion 30. The elongated through-hole 6 and the screw hole 5 are located entirely within the corner portion 30; however, the electrical component 14', which is closest to the reference point 11, is located outside the corner portion 30.

Figure 3 shows that the reference point 11 is located on the midpoint 12 of the corner 8.

Figure 3 also shows that the smallest distance 34 between the radially outer surface of the screw head 23 and the elongated through-hole 6 that is 1 mm to 2 mm.

Figure 4 shows a section of Figure 3 in an enlarged view to illustrate a smallest distance 32 from the elongated through-hole 6 to the outer contour 10 of the PCB 2 in more detail; the distance 32 is 3 mm to 4 mm. The maximum longitudinal extension 35 of the elongated through-hole 6 is larger than the maximum diameter 36 of the screw head 23.

Figures 1 to 4 show a first embodiment with the reference point 11 located on the midpoint 12 of a corner 8 of the PCB 2. However, Figure 5 shows an embodiment of a PCB 2 where the reference point 11 is not located on the corner 8; instead, it is located on a straight edge line 9a of the outer contour 10 of the PCB 2. In Figure 5 the PCB 2 has a rectangular shape, with sharp corners 8.

In Figure 5, the screw hole 5 and the elongated through-hole 6 are entirely located within an edge portion 37 that is defined by an area of the PCB 2 that is less than ¼ of the specific length 8 away from the reference point 11. The reference point 11 is defined by an intersection between a straight line 25 through the center 19 of the screw hole 5 and the edge line 9a, wherein the straight line 25 is orthogonal to the edge line 9a. The straight line 25 equals the axis of symmetry 26. The electrical component 14' that is closest to the reference point 11 is not located completely outside the edge portion 37, but it may be located completely outside the edge portion 37. In addition, the explanations given for Figures 1 and 4 apply to the embodiment of Figure 5 accordingly.

Furthermore, Figure 5 shows that the elongated through-hole 6 is located between the screw hole 5 and the electrical component 14', which is considered to be strain sensitive. Thus, the electrical component 14' can be protected from mechanical strain which is applied to the PCB 2 in the area of the screw hole 5.

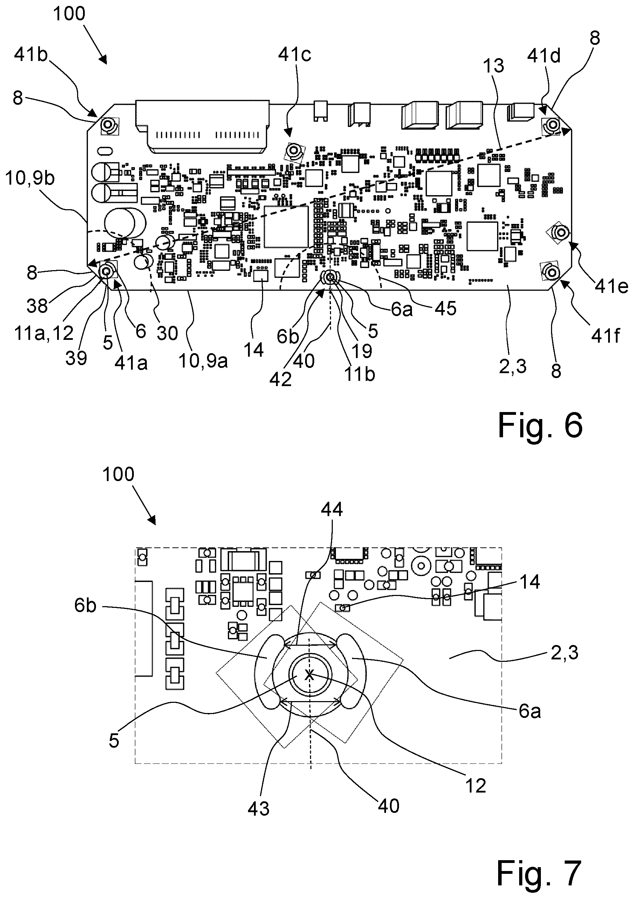

Figure 5 shows that one single elongated through-hole 6 is assigned to the reference point 11. However, it is also possible that a plurality of curved elongated through-holes 6, for example two, are assigned to the reference point 11; such an embodiment is illustrated in Figure 6.

Figure 6 shows an embodiment of a system 100 with a PCB 2 comprising a plurality of groups 41a-41f and 42 consisting of a screw hole 5 and at least one elongated through-hole 6 each.

The first groups 41a-41f consist of one screw hole 5 and one elongated through-hole 6 each, wherein a second group 42 consist of one screw hole 5 and two elongated through-holes 6.

The PCB 2 illustrated in Figure 6 is a polygon with four corners 8, wherein the four corners 8 define the polygonal shape, i.e. the rectangular basic shape, of the PCB 2. Each of the corners 8 is a straight line that connects two straight edge lines 9a and 9b extending towards the corner 8. The length of each corner 8 is considerably smaller than the length of the shortest edge line 9b; i.e., the length of the corner 8 is less than ¼ of the length of the shortest edge line 9b. The two straight edge lines 9a and 9b run to each other at an angle 28 between 70° and 110°, namely 90°. For the sake of a better overview, the angle 28 is only illustrated at one of the four corners 8.

A first reference point 11a is the midpoint 12 of the corner 8 that divides the corner 8 into two sections of equal length 38 and 39. The first group 41a is assigned to that reference point 11a; i.e., the screw hole 5 and the elongated through-hole 6 are located within a distance of less than ¼, namely less than 1/10, of the specific length 13 from the common reference point 11a. Figure 6 illustrates a plurality of first groups 41a - 41f; for the sake of a better overview only the first group 41a assigned to the reference point 11a is labeled with corresponding reference signs. For further explanations on the first group 41, reference is made to the explanations for Figures 1 to 5.

The second group 42 will be explained in more detail using Figures 6 and 7. In addition to the plurality of first groups 41a - 41f, Figure 6 also shows a second group 42 consisting of one screw hole 5 and two curved elongated through-holes 6a and 6b. The common reference point 11b of the elongated through-holes 6a and 6b and the screw hole 5 of the second group is located on the edge line 9a. In other words: The second group 42 is assigned to the reference point 11b. In this embodiment, the reference point 11b is the point on the edge line 9b that is closest to the screw hole 5. The reference point 11b and the center point 19 of the screw hole 5 of the second group 42 define an axis of symmetry 40 in the perspective shown in Fig-ure 6; i.e., in a plan view of the top surface 3. The curved elongated through-holes 6a and 6b partially surround the screw hole 5 by defining two transition cross sections 43 and 44 (cf. Figure 7), wherein the transition cross section 43 that is closer to the outer contour 10 is larger than the transition cross section 44 facing away from the closest outer contour 10 of that second group 42, i.e. from the straight edge line 9a. The elongated through-holes 6a and 6b are axially symmetrical with respect to the axis of symmetry 40, which can be clearly seen in the detailed view of Figure 7. However, other arrangements of the elongated through-holes 6a and 6b are also possible. The two curved elongated through-holes 6a, 6b are positioned on both sides of the screw hole 5 and therefore on both sides of the screw 7 when mounted to the carrier 22 (see Figure 1); this ensures a balanced distribution of stress and improves the overall durability of the system 100. Regarding the shape and the dimensions of the screw hole 5 and the elongated through-holes 6a and 6b, it is referred to the embodiments shown in Figures 1 to 5. The screw hole 5 and the two elongated through-holes 6a and 6b of the second group 42 are located entirely within a distance of less than 1/10 of the specific length 13 of the PCB 2 from the common reference point 11b. A corresponding edge portion 45 is illustrated by the dotted semi-circle around the reference point 11b.

## Claims

1. Device (1) with a printed circuit board (PCB) (2), wherein the PCB (2) comprises
- a top surface (3),
- a bottom surface (4) on an opposite side of the top surface (3),
- a screw hole (5) for receiving a screw (7), and
- a curved elongated through-hole (6), wherein
- a specific length (13) of the PCB (2) is defined by the maximum extension of the PCB (2) in a plan view of the top surface (3), wherein
- the elongated through-hole (6) and the screw hole (5) are assigned to a common reference point (11) that is located on an outer contour (10) of the PCB (2), **characterized in that**
- the elongated through-hole (6) and the screw hole (5) that are assigned to the common reference point (11) are located entirely within a distance of less than 1/4 of the specific length (13) from the common reference point (11) .

2. Device (1) according to claim 1, **characterized in that**
- in a plan view of the top surface (3), the outer contour (10) of the PCB (2) comprises at least one corner (8) and at least two edge lines (9a, 9b) that extend towards the corner (8), wherein
- the corner (8) forms a transition between the two edge lines (9a, 9b), wherein
- the common reference point (11) is a point on the corner (8).

3. Device (1) according to claim 2, **characterized in that**
- the two edge lines (9a, 9b) that extend towards the corner (8) are straight or essentially straight.

4. Device (1) according to claim 3, **characterized in that**
- the two edges lines (9a, 9b) run to each other at an angle (28) between 70° and 110°.

5. Device (1) according to any of the claims 2 to 4, **characterized in that**
- the common reference point (11) is defined by a point of the corner (8) with the maximum degree of curvature in a plan view of the top surface (3); or
- the corner (8) extends along a path that defines a corner length, wherein the reference point (11) is a midpoint (12) that divides the path into two sections of equal length (38, 39).

6. Device (1) according to any of the claims 2 to 5, **characterized in that**
- in a plan view of the top surface (3), the PCB (2) has a polygonal basic shape, wherein
- the corner (8) on which the reference point (11) is located is a corner (8) defining the polygonal basic shape.

7. Device (1) according to any of the preceding claims, **characterized in that**,
- the average distance of the screw hole (5) to the reference point (11) is less than the average distance of the elongated through-hole (6) to the reference point (11) .

8. Device (1) according to any of the preceding claims, **characterized in that**
- at least one electrical component (14) is located on the top surface (3) of the PCB (2) and is electrically connected to the PCB (2), wherein
- the distance between the furthest point (31) of the elongated through hole (6) to the reference point (11) is less than the smallest distance between the reference point (11) and the electrical component (14) that is closest to the reference point (11).

9. Device (1) according to any of the preceding claims, **characterized in that**
- the maximum width (15) of the elongated through-hole (6) is 0.4 to 2 mm.

10. Device (1) according to any of the preceding claims, **characterized in that**
- the smallest distance (32) from the elongated through-hole (6) to the outer contour (10) of the PCB (2) is 3 mm to 4 mm.

11. Device (1) according to any one of the preceding claims, **characterized in that**
- in a plan view of the top surface (3), the elongated through-hole (6) extends over an angle (18) between 60° and 120° defined by two straight angle-defining lines (16, 17) running through a center point (19) of the screw hole (5) that is assigned to the same reference point (11) as the elongated through-hole (6), wherein
- the straight angle-defining lines (16, 17) traverse the outer contour (24) of said elongated through-hole (6).

12. Device (1) according to any of the preceding claims, **characterized in that**
- the PCB (2) comprises a plurality of groups, each consisting of one screw hole (5) and at least one elongated through-hole (6), wherein
- each group is assigned to a different reference point (11) that is located on the outer contour (10) of the PCB (2).

13. Device (1) according to any of the preceding claims, **characterized in that**
- in a plan view of the top surface (3), an axis of symmetry (26) that extends through the reference point (11) and a center point (19) of the screw hole (5) crosses the elongated through-hole (6) that is assigned to the same reference point as said screw hole (5), wherein in a plan view of the top surface (3), the elongated through-hole (6) is symmetric with respect to the axis of symmetry (26).

14. Device (1) according to any of the preceding claims, **characterized in that**
- in a plan view of the top surface (3), the elongated through-hole (6) is arc-shaped.

15. System (100) comprising a carrier (22) and a screw (7), **characterized in that** the system (100) further comprises
- a device (1) according to any of the preceding claims, wherein
- the screw (7) mounts the PCB (2) to the carrier (22) in a non-detachable manner, wherein the screw (7) protrudes through the screw hole (5), wherein
- the smallest distance (34) between the radially outer surface of a screw head (23) of the screw (7) and the elongated through-hole (6) is 1 mm to 2 mm.
